Europäisches Patentamt

European Patent Office

Office européen des brevets

(19)

(11) Publication number: **0 153 170**
A2

## EUROPEAN PATENT APPLICATION

(21) Application number: 85301029.6

(22) Date of filing: 15.02.85

(51) Int. Cl.⁴: **H 01 L 29/267**

(30) Priority: 17.02.84 US 581140
28.01.85 US 695268

(43) Date of publication of application: 28.08.85
Bulletin 85/35

(84) Designated Contracting States: BE CH DE FR GB IT LI
LU NL SE

(71) Applicant: STAUFFER CHEMICAL COMPANY, Westport
Connecticut 06881 (US)

(72) Inventor: Olego, Diego Jose, 28T Scenic Drive,
Croton-on-Hudson, N.Y. 10520 (US)

(74) Representative: Smith, Sydney et al, Elkington and Fife
High Holborn House 52/54 High Holborn, London
WC1V 6SH (GB)

(54) Phosphorus and high phosphorus polyphosphide barriers in quantum well devices.

(57) A semiconductor device characterised in that it comprises:

(A) a layer of semiconductor material comprising an intermetallic semiconductor; and

(B) a first barrier layer adjacent one side of the said semiconductor layer, which barrier layer comprises phosphorus is disclosed.

Referring to the accompanying diagram, a semiconductor device 20 may comprise an intermetallic semiconductor layer 22 and barrier layers 23 and 24, the interface 26 causes a quantum well to develop.

A method of making a quantum well device characterised in that it comprises depositing a barrier layer comprising phosphorus on an intermetallic semiconductor comprising a pnictide is also disclosed.

Phosphorus and polyphosphides $MP_x$, wherein M represents an alkali metal and x varies from 16 to infinity, have bandgaps larger than those of many of the currently used binary, ternary and quaternary semiconductors and have good interface properties therewith. Layers of phosphorus and such polyphosphides may be used as barriers in quantum well devices, particularly those using other semiconductor layers comprising a pnictide. The barrier layers may be, for example, $MP_x$ wherein x varies from 15 to infinity, M represents an alkali metal and P represents phosphorus. Phosphorus is the preferred barrier layer and may be monoclinic phosphorus, red phosphorus or amorphous phosphorus having a layer-like, puckered sheet-like local order. Quantum well and hetero-junction devices are further disclosed. These have applications in field effect devices, such as MESFETS, ring oscillators, two-dimension electron gas transistors, photodetectors and lasers.

The present invention provides advantages over the prior art.

"Phosphorus and high phosphorus polyphosphide barriers in quantum well devices"

---

This invention relates to phosphorus and high phosphorus polyphosphide barriers in quantum well devices; more particularly, it relates to such quantum well devices hetero-junction devices, field effect transistors, MESFETS, ring oscillators, two-dimensional electron gas transistors, photo-detectors and lasers employing such barriers.

For further information, reference may be made to, for example, GB-A- 2,113,663, EP-A-130803, EP-A- 132323, EP-A-132954, EP-A-132326 and EP-A-132322, also to as yet unpublished European Applications 84 304 407.4, 84 304 411.6, 84 304 412.4, 84 304 413.2 and 84 304 414.0 and USSN 619,053, as well as to the related application filed herewith based on USSN 581,171 and USSN 695,255.

Various phosphorus and high phosphorus polyphosphide allotropes have bandgaps which are larger than those of many pnictide-containing binary, ternary and quaternary semiconductors currently employed in quantum well hetero-junction devices. Such allotropes may be grown as thin films with good adherence and interface properties to such semiconductors. See, for example, EP-A-132326.

It is therefore an object of the present invention to provide barriers in quantum well devices.

Another object of the present invention is to provide such barriers of phosphorus and high phosphorus polyphosphides.

A further object of the present invention is to provide such barriers in quantum well devices wherein the well semiconductor material comprises a pnictide, particularly III-V semiconductors.

The present invention relates to a semiconductor device characterised in that it comprises:

(A)     a layer of semiconductor material comprising an intermetallic semiconductor; and

(B)     a first barrier layer adjacent one side of the said semiconductor layer, which barrier layer comprises phosphorus.

Such a device may further comprise:

(C) a second barrier layer adjacent the side of the said first barrier layer away from the said semiconductor layer, which comprises a material selected from phosphorus and $MP_x$, wherein M represents an alkali metal and x ranges from 15 to infinity.

For example, the said first barrier layer may comprise $MP_x$, wherein M represents an alkali metal and x ranges from 15 to infinity.

The said second barrier layer may differ in conductivity from the said first barrier layer. One of the said barrier layers may be doped, while the other, for example the first, is undoped.

Such a device may further comprise:

(D) a third barrier layer adjacent the other side of the said semiconductor layer, which comprises a material selected from phosphorus and $MP_x$, wherein M represents an alkali metal and x ranges from 15 to infinity.

In this case, the first and third barrier layers may differ in conductivity from the second barrier layer, for example by virtue of doping. More particularly, the first and third barrier layers may be undoped, while the second is doped.

Such a device may further comprise:
(E) a fourth barrier layer adjacent the other side of the said third barrier layer.

In this case, the first and third barrier layers may differ in conductivity from the second and fourth barrier layers, for example by virtue of doping. More particularly, the first and third barrier layers may be undoped, while the second and fourth are doped.

In summary, there may be a difference in conductivity between the said first barrier layer and the said second barrier layer (when present), or between the said first and third (when present) barrier layers and the said second barrier layer (when present), or between the said first and third (when present) barrier layers and the said second and fourth barrier layers (when present).

This may be due to a difference in doping between the layers or layer pairs.

The intermetallic semiconductor in such devices may comprise a pnictide or a III-V semiconductor. Preferably, at least one of the barrier layers comprises amorphous phosphorus having a layer-like, puckered, sheet-like local order or monoclinic phosphorus or red phosphorus.

The present invention also relates to a method of making quantum well devices characterised in that it comprises depositing a barrier layer comprising phosphorus on an intermetallic semiconductor comprising a pnictide.

As the barrier layer in such method, it may be preferred to use $MP_x$ (as defined above).

Phosphorus and high phosphorus polyphosphide barrier layers may be employed in quantum well (hetero-junction) devices by depositing a pair of successive barrier layers on top of a pnictide-containing intermetallic semiconductor, such as InP, when these barrier layers have larger bandgaps than the intermetallic semiconductors. One of the barrier layers is doped, for example, with Ni, and the other undoped. Such pairs of layers may be established on both sides of a semiconductor layer containing a pnictide. This structure may be repeated to form a hetero-junction device. The barrier layers adjacent the pnictide-contianing semiconductor are undoped and the next barrier layer is doped to provide electrons for the semiconductor layer. The present invention is applicable to all III-V semiconductors having smaller bandgaps than the present barrier layers.

Referring to the illustrative accompanying drawings:

Figure 1 is a diagrammatic cross-sectional view of a quantum well device according to the present invention;

Figure 2 is a band diagram of the device illustrated in Figure 1;

Figure 3 is a diagrammatic cross-sectional view of a hetero-junction multiple quantum well device according to the present invention; and

Figure 4 is a band diagram of the device illustrated in Figure 3.

(The same reference characters refer to the same elements throughout the several views of the drawings.)

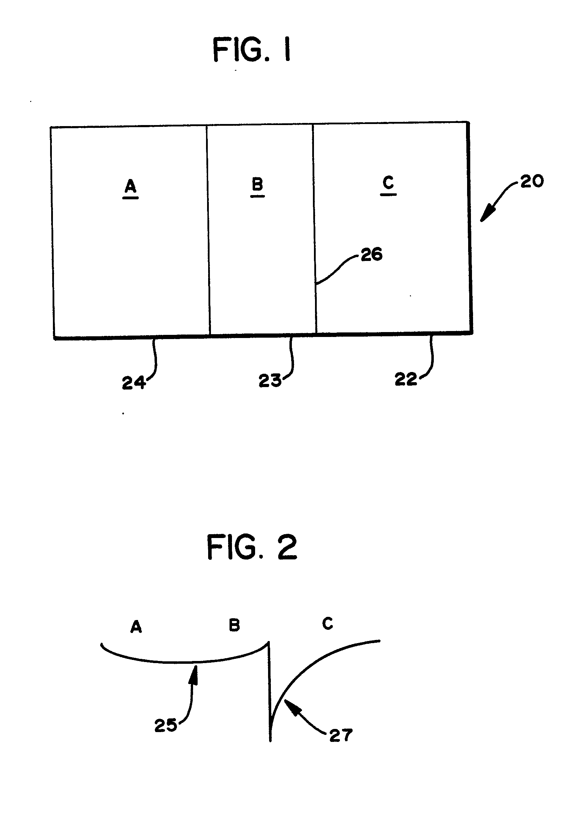

Referring to Figure 1, a single hetero-junction device according to the present invention is generally indicated at 20. It comprises three layers, 22, 23 and 24. Layer 22 is a typical intermetallic semiconductor utilized in such devices which may be binary, ternary or quaternary, and preferably comprises a pnictide. Layers 23 and 24 are barrier layers of phosphorus or high phosphorus polyphosphide deposited on semiconductor layer 22. Barrier layer 24 is doped with Ni, for example. This increases its conductivity over the conductivity of undoped layer 23 and provides a source of free electron for layer 22. Barrier layers 23 and 24 have larger bandgaps than the semiconductor layer 22.

This structure provides a quantum well. In accordance with the band diagram shown in Figure 2, layers A and B establish a barrier generally indicated at 25. The interface 26 between layers 22 and 23 causes a quantum well to develop as indicated at 27, adjacent this interface. An electron gas may be trapped in the well 27 and provides for the desired quantum well action.

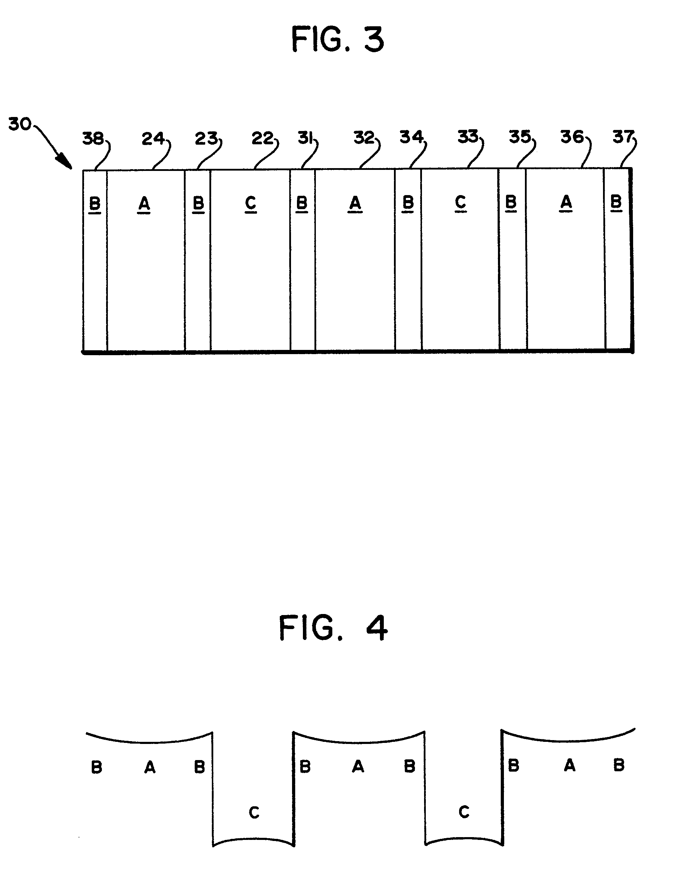

In multiple hetero-junction devices, such as the one generally indicated at 30 in Figure 3, the layers are multiply repeated; that is, there is a layer of intermetallic semiconductor 22 and barrier layers 23 and 24. Additionally, similar barrier layers 31 and 32 are placed on the other side of the semiconductor layer 22. Another semiconductor layer 33 has barrier layers 34 and 32 on one side of it, which are the equivalent of barrier layers 23 and 24 on the left side of semiconductor layer 22. To the right of semiconductor layer 33, barrier layers 35 and 36 have the same composition as barrier layers 31 and 32 on the right side of semiconductor layer 22. Another barrier layer 37 is similar to barrier layer 23 and may be next to

-6-

another layer of semiconductor material (not shown). Similarly, barrier layer 38 to the left of layers 23 and 24 may be adjacent to another semiconductor layer (not shown) so that the device 30 may be iterated in both directions.

The barrier layers labelled "A" are doped to provide a source of electrons. The barrier layers labelled "B" are undoped. The intermetallic or compound semiconductor layers are labelled "C".

Typical thickness of the layers are:

A. from 100 to 500 $\overset{o}{A}$   ($10^{-8}$ cm)
B. from 50  to 100 $\overset{o}{A}$
C. from 100 to 500 $\overset{o}{A}$

The structures may be used in high speed field effect transistors, such as MESFETS, ring oscillators, two-dimensional electron gas transistors, photo-detectors and lasers.

The semiconductor layers "C" preferably comprise a pnictide so that the barrier layers "B" obtain some atomic matching with the surface pnictide atoms of the semiconductor layers "C".

In particular, the semiconductor body 22 may comprise III-V materials, such as GaAs, InP, GaP and InGaAsP, and the barrier layers are preferably phosphorus, for example, monoclinic phosphorus (bandgap approximately 1.9-2.0 eV), red phosphorus (bandgap approximately 2.0 eV), or the new form of amorphous phosphorus having a layer-like, puckered sheet-like local order, disclosed in EP-A-132326, for example, (bandgap approximately 1.7 eV; or the barrier layers may be an alkali metal polyphosphide $MP_x$ wherein P represents

phosphorus, M represents an alkali metal and x ranges from 15 to infinity (bandgap approximately 1.7-1.8 eV). $KP_{15}$ is the preferred polyphosphide.

The semiconductors according to the present invention comprising pnictides are commonly called intermetallic or compound. III-V semiconductors which are compound, intermetallic, semiconductors comprise elements from group III and group V of the Periodic Table, such as gallium phosphide, gallium arsenide, gallium antimonide, indium phosphide, indium arsenide, indium antimonide, indium gallium arsenide, indium gallium phosphide, indium aluminium arsenide, indium gallium arsenide phosphide and indium gallium aluminium arsenide, which have bandgaps smaller than the barrier layers employed. By pnictide is meant those elements from group V of the Periodic Table, namely nitrogen, phosphorus, arsenic, antimony and bismuth.

The barrier layers utilized in accordance with the present invention must have good interfacial properties with the pnictide-containing intermetallic semiconductors and must have a band gap higher than that of the semiconductor employed. Both elemental phosphorus and high phosphorus polyphosphides ($MP_x$, wherein M represents an alkali metal and x varies from 15 to infinity) have such qualities. Thus, one aspect of the present invention is that the barrier layers consist essentially of phosphorus.

Claims:

1.  A semiconductor device (20) characterised in that it comprises:

(A) a layer of semiconductor material (22) comprising an intermetallic semiconductor; and

(B) a first barrier layer (23) adjacent one side of the said semiconductor layer, which barrier layer comprises phosphorus.

2.  A semiconductor device as claimed in claim 1 further comprising:

(C) a second barrier layer (24) adjacent the side of said first barrier layer away from the said semiconductor layer, which comprises a material selected from phosphorus and $MP_x$, wherein M represents an alkali metal and x ranges from 15 to infinity;

and, optionally,

(D) a third barrier layer (31) adjacent the other side of the said semiconductor layer, which comprises a material selected from phosphorus and $MP_x$, wherein M represents an alkali metal and x ranges from 15 to infinity;

and, optionally

(E) a fourth barrier layer (32) adjacent the other side of the said third barrier layer.

3.  A semiconductor device as claimed in claim 1 or claim 2 the said first barrier layer comprises $MP_x$, wherein M represents an alkali metal and x ranges from 15 to infinity.

4.  A semiconductor device as claimed in any of claims 1 to 3 wherein there is a difference in conductivity between the said first barrier layer and the said second layer (when present) or between the said first layer

and third (when present) barrier layers and the said second barrier layer (when present), or between the said first and third (when present) barrier layers and the said second and fourth barrier layers (when present).

5. A semiconductor device as claimed in claim 4 wherein there is a difference in doping between the said layers or layer pairs.

6. A device as claimed in any of claims 1 to 5 wherein the said intermetallic semiconductor comprises a pnictide or a III-V semiconductor.

7. A device as claimed in any of claims 1 to 6 wherein at least one of the said barrier layers comprises amorphous phosphorus having a layer-like, puckered, sheet-like local order or monoclinic phosphorus or red phosphorus.

8. A method of making a quantum well device characterised in that it comprises depositing a barrier layer comprising phosphorus on an intermetallic semiconductor comprising a pnictide.

9. A method as claimed in claim 8 wherein the said barrier layer comprises $MP_x$, wherein M represents an alkali metal and x ranges from 15 to infinity.

## FIG. 1

| A | B | C |
|---|---|---|

26

20

24    23    22

## FIG. 2

A    B    C

25    27

## FIG. 3

## FIG. 4